# EUROPEAN PATENT APPLICATION

(11) **EP 3 748 691 A1**
(43) Date of publication of application: **09.12.2020**
(21) Application number: 19775312.2
(22) Date of filing: 28.01.2019
(51) Int. Cl.: H01L 31/0216, H01L 31/0236, H01L 31/054, H01L 31/056

(54) **SOLAR CELL MODULE**

(30) Priority: 30.01.2018 CN 201810090864; 30.01.2018 CN 201820157682 U
(71) Applicant: 3M Innovative Properties Company, St. Paul, MN 55133-3427 (US)
(72) Inventor: MA, Jiaying, Saint Paul, MN 55133-3427 (US); NARUM, Timothy N., Saint Paul, MN 55133-3427 (US); O'NEILL, Mark B., Saint Paul, MN 55133-3427 (US)
(74) Representative: Mathys & Squire
(86) International application number: PCT/IB2019/050672
(87) International publication number: WO 2019/186287

(57) **Abstract**

The present invention provides a solar cell module, which comprises: a back panel, a rear package layer, a plurality of mutually spaced solar cells, a front package layer, and a light-transmissive element, which are successively disposed along a thickness direction of the solar cell module. The solar cell module further comprises at least one light redirecting film, each light redirecting film comprising an optical structure layer. The light redirecting film is disposed on a surface, opposite to the side where the solar cells are located, of the rear package layer; the position of the light redirecting film corresponds to a region between the solar cells. The optical structure layer faces the rear package layer, such that the optical structure layer reflects the light towards an interface between the light-transmissive element and the air; and the light is then totally internally reflected to light-facing surfaces of the solar cells. The solar cell module has high electricity generation efficiency, and is further optimized in optical gain, electrical insulation property, and thermal/mechanical stress properties.

## Description

### TECHNICAL FIELD

The present invention relates to the field of solar cells, and in particular, to a solar cell module.

### BACKGROUND

A solar cell module generally includes a package back panel, a rear package layer, a battery main body, a front package layer, and a package cover plate, which are successively stacked along a thickness direction of the solar cell module. The battery main body comprises a plurality of battery pieces spaced from each other at an interval.

Each battery piece has limited surface area on the solar cell module. Therefore, the question of how to increase the amount of electricity generated by the solar cell module is a technical problem urgently need to be solved in this field. Presently in the field, a light redirecting film is applied into the solar cell module to enhance sunlight utilization of the solar cell module, so as to improve electricity generation efficiency and the amount of electricity generated. However, the existing solar cell modules that adopt light redirecting films still have room for further optimization in optical gain, electrical insulation property, and thermal/mechanical stress properties.

### SUMMARY

The objective of the present invention is to provide a solar cell module which has high electricity generation efficiency.

To achieve the foregoing objective, one aspect of the present invention provides a solar cell module, the solar cell module comprising: a back panel, a rear package layer, a plurality of mutually spaced solar cells, a front package layer, and a light-transmissive element, which are successively disposed along a thickness direction of the solar cell module, wherein the solar cell module further comprises at least one light redirecting film, each light redirecting film comprising an optical structure layer. The light redirecting film is disposed on a surface, opposite to the side where the solar cells are located, of the rear package layer, and the position of the light redirecting film corresponds to a region between the solar cells. The optical structure layer faces the rear package layer, such that the optical structure layer reflects the light towards an interface between the light-transmissive element and the front package layer; and the light reflected by the optical structure layer is propagated to an interface between the light-transmissive element and the air, and is then totally internally reflected from the interface between the light-transmissive element and the air to the surfaces of the solar cells.

Preferably, the solar cell module further comprises an adhesive tape, wherein one part of the adhesive tape is adhered onto a surface, away from the rear package layer, of the light redirecting film; and another part of the adhesive tape is adhered onto a surface, different from the side where the solar cells are located, of the rear package layer, so as to affix the light redirecting film onto the surface, different from the side where the solar cells are located, of the rear package layer.

Preferably, the light-transmissive element is made of glass, and the front and rear package layers are made of ethylene-vinyl acetate (EVA).

Preferably, each optical structure layer comprises: a microstructure layer; a reflective layer, made of metal, disposed on the microstructure layer; and an optional transparent insulating layer disposed on the reflective layer.

Preferably, the microstructure layer comprises a plurality of triangular prisms; and vertex angles of the plurality of triangular prisms range from 100° to 140°, preferably from 110° to 130°.

Preferably, straight lines perpendicular to the triangular prisms' smallest cross sections are defined to be trends of the triangular prisms; and the trends of the triangular prisms are parallel to the length direction of the light redirecting film, on which the triangular prisms are located.

Preferably, straight lines perpendicular to the triangular prisms' smallest cross sections are defined to be trends of the triangular prisms; and the trends of the triangular prisms form an angle with respect to the length direction of the light redirecting film, on which the triangular prisms are located.

Preferably, the angle of the trends of the triangular prisms with respect to the length direction of the light redirecting film, on which the triangular prisms are located, ranges from 1° to 89°.

Preferably, the transparent insulating layer is made of silicon oxide.

Preferably, the silicon oxide comprises silicon dioxide; and the transparent insulating layer has a thickness of from 20 nm to 100 nm, and preferably has a thickness of from 20 nm to 50 nm.

Preferably, the transparent insulating layer is made of one or a plurality of EVA, polyolefin (PO), and low-density polyethylene (LDPE).

Preferably, the transparent insulating layer comprises one of the following materials, or a material formed after cross-linking a plurality of the following materials: EVA, PO, and LDPE.

The total thickness of the light redirecting films ranges from 20 µm to 150 µm, preferably not exceeding 75 µm, and more preferably not exceeding 50 µm.

Another aspect of the present invention provides a solar cell module, comprising: a rear light-transmissive element, a rear package layer, a plurality of mutually spaced solar cells, a front package layer, and a front light-transmissive element, which are successively disposed along a thickness direction of the solar cell module, wherein the solar cell module further comprises at least one light redirecting film, each light redirecting film comprising an optical structure layer; the optical structure layer is disposed on a surface, inside the solar cell module, of the rear light-transmissive element; the position of the optical structure layer corresponds to a region between the solar cells; the optical structure layer faces the rear package layer, such that the optical structure layer reflects the light towards an interface between the front light-transmissive element and the front package layer; and the light reflected by the optical structure layer is propagated to an interface between the front light-transmissive element and the air, and is then totally internally reflected from the interface between the front light-transmissive element and the air to the surfaces of the solar cells.

Preferably, the light redirecting film is disposed on the surface, inside the solar cell module, of the rear light-transmissive element by using an adhesive; the adhesive contains an ultraviolet absorbent.

Preferably, the front and rear light-transmissive elements are made of glass, and the front and rear package layers are made of EVA.

Preferably, each optical structure layer comprises: a microstructure layer; a reflective layer, made of metal, disposed on the microstructure layer; and an optional transparent insulating layer disposed on the reflective layer.

Preferably, the microstructure layer comprises a plurality of triangular prisms; and vertex angles of these triangular prisms range from 100° to 140°, preferably from 110° to 130°.

Preferably, straight lines perpendicular to the triangular prisms' smallest cross sections are defined to be trends of the triangular prisms; and the trends of the triangular prisms are parallel to the length direction of the light redirecting film, on which the triangular prisms are located.

Preferably, straight lines perpendicular to the triangular prisms' smallest cross sections are defined to be trends of the triangular prisms; and the trends of the triangular prisms form an angle with respect to the length direction of the light redirecting film, on which the triangular prisms are located.

Preferably, the angle of the trends of the triangular prisms with respect to the length direction of the light redirecting film, on which the triangular prisms are located, ranges from 1° to 89°.

Preferably, the transparent insulating layer is made of silicon oxide.

Preferably, the transparent insulating layer is made of one or a plurality of EVA, PO, and LDPE.

Preferably, the transparent insulating layer comprises one of the following materials, or a material formed after cross-linking a plurality of the following materials: EVA, PO, and LDPE. Preferably, the total thickness of the light redirecting films ranges from 20 µm to 150 µm, preferably not exceeding 75 µm, and more preferably not exceeding 50 µm.

Preferably, each solar cell is a double-sided solar cell, such that the solar cells are able to use the light entering the solar cell module from both the front light-transmissive element and the rear light-transmissive element.

In the solar cell module provided by the present invention, a positionally fixed light redirecting film is arranged, optimizing the solar cell module in optical gain, electrical insulation property, and thermal/mechanical stress properties.

### BRIEF DESCRIPTION OF THE DRAWINGS

The accompanying drawings are provided to facilitate a better understanding of the present invention. The accompanying drawings constitute a part of the Description, and, together with the following embodiments, serve to explain the present invention. However, they are not to limit the present invention. In the accompanying drawings:
FIG. 1 is a schematic structural diagram of a solar cell module in Embodiment 1 of the present invention;
FIG. 2 is a schematic structural diagram of a light redirecting film in the solar cell module in FIG. 1;
FIG. 3 is a schematic diagram of a solar cell module in Embodiment 1 of the present invention after a lamination process, where black grids are used as reference lines;
FIG. 4a shows a reflectivity curve of a test sample 1 exposed to light of different wavelengths;
FIG. 4b shows a reflectivity curve of a test sample 2 exposed to light of different wavelengths;
FIG. 4c shows a reflectivity curve of a test sample 3 exposed to light of different wavelengths;
FIG. 4d shows a reflectivity curve of a test sample 4 exposed to light of different wavelengths;
FIG. 4e shows a reflectivity curve of a test sample 5 exposed to light of different wavelengths;
FIG. 4f shows a reflectivity curve of a test sample 6 exposed to light of different wavelengths;
FIG. 4g shows a reflectivity curve of a comparative sample exposed to light of different wavelengths;
FIG. 5 is a schematic diagram of a solar cell module in Embodiment 2 of the present invention;
FIG. 6 is a schematic diagram of a light redirecting film in the solar cell module in FIG. 2; and
FIG. 7 is a schematic diagram of a solar cell module in Embodiment 2 of the present invention after a lamination process, where black grids are used as reference lines.

### DETAILED DESCRIPTION

The present invention is described in detail below with reference to the accompanying drawings. It should be understood that the embodiments described herein are for illustration and explanation purposes only and are not intended to limit the present invention.

### Embodiment 1

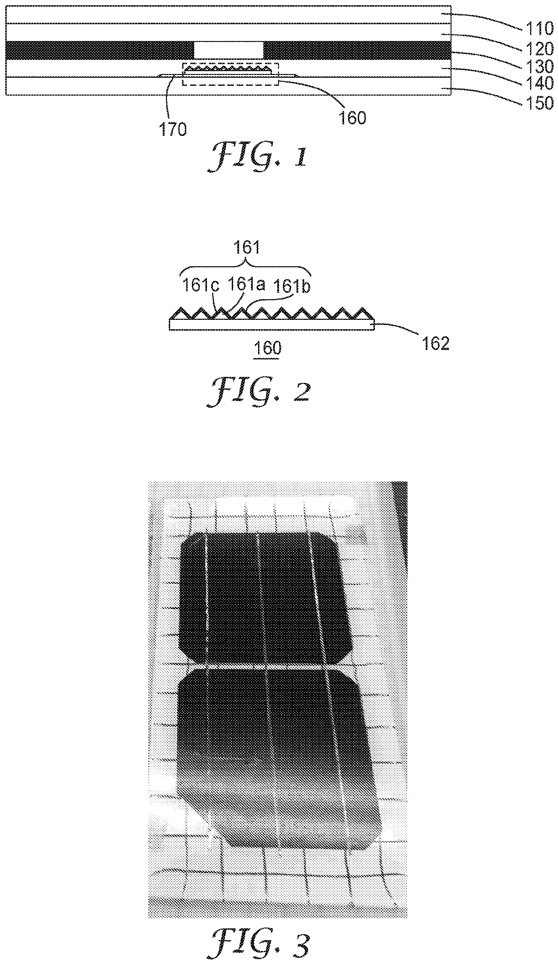

Embodiment 1 of the present invention provides a solar cell module. As shown in FIG. 1, the solar cell module comprises: a back panel 150, a rear package layer 140, a plurality of mutually spaced solar cells 130, a front package layer 120, and a light-transmissive element 110, which are successively disposed along a thickness direction of the solar cell module. The back panel 150 is generally made of a fluoropolymer, and has satisfactory weather fastness. For example, the back panel may be a TPT panel, a TPE panel, a BBF panel, or a panel of another type. The front package layer 120 and the rear package layer 140 are package film layers generally made of EVA, and are used to package the solar cell module. The light-transmissive element 110 is generally made of glass material, such as high-strength tempered glass. The solar cell module further comprises at least one light redirecting film 160, and each light redirecting film 160 comprises an optical structure layer. The light redirecting film 160 is disposed on a surface (that is, the lower surface of the rear package layer 140 in FIG. 1), opposite to the side where the solar cells 130 are located, of the rear package layer 140. The position of the light redirecting film 160 corresponds to a region between the solar cells 130. The optical structure layer faces the rear package layer 140, such that the optical structure layer reflects the light towards an interface between the light-transmissive element 110 and the front package layer 110. The light reflected by the optical structure layer is propagated to an interface between the light-transmissive element 110 and the air, and is then totally internally reflected from the interface between the light-transmissive element 110 and the air to the surfaces of the solar cells.

In this embodiment, the situation that "the position of the light redirecting film 160 corresponds to a region between the solar cells 130" refers to that a projection of an interval between two adjacent solar cells 130 on the back panel 150 (that is, an orthographic projection of a region between the two solar cells 130 on the back panel 150) at least partially overlaps an orthographic projection of a corresponding light redirecting film 160 on the back panel 150.

During electricity generation, the light-transmissive element 110 of the solar cell module is arranged against the light. The light is incident through the light-transmissive element 110. Part of the light passes through the light-transmissive element 110 and the front package layer 120, and directly falls on light-facing surfaces of the solar cells 130, and then the solar cells convert optical energy into electric energy. Part of the light passes through the light-transmissive element 110, the front package layer 120, the region between the solar cells 130, and the rear package layer 140, and falls on the light redirecting film 160 corresponding to the region between the solar cells. Then, the light is reflected by the light redirecting film 160 to the light-transmissive element 110, and is propagated from the light-transmissive element 110 to a surface of the interface between the light-transmissive element and the air. The light-transmissive element 110 is an optically denser medium, while the air is an optically thinner medium. Therefore, the light is totally internally reflected when shining on the interface between the light-transmissive element 110 and the air; then is propagated through the light-transmissive element 110 and the front package layer 120, and finally reaches the light-facing surfaces of the solar cells 130. The solar cells 130 can use this part of light for electricity generation.

In this embodiment, the disposition of the light redirecting film 160 can enhance the utilization of the light incident on the solar cell module, and improve the electricity generation efficiency of the solar cells.

As described above, the front package layer and the rear package layer are made of an organic material (for example, EVA). Generally, the glass transition temperature of the organic material is less than 100°C (for example, the glass transition temperature Tg of the EVA is 70°C). During manufacturing of the solar cell module, the temperature of a lamination process ranges from 145°C to 160°C. Therefore, during the lamination process, the organic material for making the front package layer and the organic material for making the rear package layer are both in a molten state. Thus, the organic materials may flow/shift during the lamination process.

In this embodiment, the reason for fixing the light redirecting film 160 on the rear package layer 140 is as follows: The inventors find that, when the solar cell module is a type combining the back panel and glass, and if the light redirecting film 160 is fixedly disposed on the rear package layer 140, the thin light redirecting film 160 does not produce stress when the rear package layer made of, for example, EVA, is melted during the lamination process of the solar cell module, and thus undesired folds may not occur on the exterior of the light redirecting film 160. However, if the light redirecting film 160 is disposed on the back side (namely, the lower surface) of the solar cell or on the back panel (namely, the surface, of the back panel, inside the module), undesired folds may occur on the light redirecting film 160.

Moreover, the inventors discovered the following: during lamination of a type of solar cell module that combines the back panel and glass, the rear package layer made of a material such as EVA shifts relatively less because the back panel is made of a soft material. The inventors further discovered that, during lamination of the solar cell module, a shear force mainly occurs in corners of the module. Therefore, shifting of the rear package layer may not occur in the middle area of the module. Therefore, if the light redirecting film is disposed at a position corresponding to the region between the solar cells, instead of the outer side of the outermost solar cell, the corresponding shear force is not strong enough to move the light redirecting film even if the rear package layer is melted during the lamination. The content above will be described below by using specific tests.

In addition, the arranging the light redirecting film 160 between the rear package layer 140 and the back panel 150, and making the optical structure layer face the rear package layer 140, can prevent the occurrence of bubbles at the optical structure layer of the light redirecting film 160. Specifically, during the lamination process after the light redirecting film 160 is disposed on the rear package layer 140, the rear package layer 140 made of a material such as EVA is melted and is used to fill the gaps in the optical structure layer of the light redirecting film 160, so as to prevent the occurrence of bubbles.

The situation that a shear force in the peripheral region of the cell module is greater than that in the middle region of the cell module is confirmed and explained through a test below.

First, a black marker pen is used to draw black grids on the front package layer as reference lines. Then, the back panel, the light redirecting film, the rear package layer, the solar cells, the front package layer, and the light-transmissive element are assembled into a semi-finished product, and then the lamination process is performed. The temperature of the lamination process ranges from 145°C to 160°C. The lamination process lasts for 20 min. After the lamination process is finished, the obtained solar cell module is photographed, as shown in FIG. 3. It can be seen that, the reference lines in the middle region of the solar cell module do not change much, while those in the peripheral region of the solar cell module are obviously bent and deformed. Thus, it is confirmed that, the peripheral region of the solar cell module is subjected to a larger shear force during the lamination process.

Therefore, in the present invention, the light redirecting film is disposed only at the position corresponding to the interval between two adjacent solar cells. The light redirecting film at this position is subjected to a small shear force during the lamination process, and therefore does not drift in position.

Preferably, the light redirecting film is disposed at every position corresponding to a region between any two solar cell sheets, thus maximizing the utilization of the light incident on the solar cell module.

The present invention does not particularly limit the manner of fixing the light redirecting film 160 on the rear package layer 140. As a preferred implementation, as shown in FIG. 1, the solar cell module comprises an adhesive tape 170 (for example, the UV-1 tape of the 3M Company) which is used to affix the light redirecting film 160 onto a surface (that is, the lower surface of the rear package layer 140 in FIG. 1), different from the side where the solar cells 130 are located, of the rear package layer 140. Specifically, one part of the adhesive tape 170 is adhered onto a surface (that is, a lower surface of the light redirecting film 160 in FIG. 1), away from the rear package layer 140, of the light redirecting film 160; and another part of the adhesive tape 170 is adhered onto a surface (that is, the lower surface of the rear package layer 140 in FIG. 1), different from the side where the solar cells 130 are located, of the rear package layer 140, so as to affix the light redirecting film 160 onto the surface, different from the side where the solar cells 130 are located, of the rear package layer 140.

In summary, in the present invention, the adhesive tape 170 can be used to adhere the light redirecting film 160 onto the rear package layer 140, and thus the position of the light redirecting film 160 on the rear package layer 140 can be affixed, avoiding the light redirecting film 160 from drifting in position during the lamination process.

This embodiment does not particularly specify the specific structure of the light redirecting film 160. The only requirement is that the light redirecting film 160 can achieve the above-described function of "reflecting the light towards the interface between the light-transmissive element 110 and the front package layer 120, such that the light reflected by the optical structure layer is propagated to the interface between the light-transmissive element 110 and the air, and is then totally internally reflected from the interface between the light-transmissive element and the air to the surfaces of the solar cells." For example, as shown in FIG. 2, the light redirecting film 160 comprises an insulating substrate 162 and an optical structure layer 161 disposed on the insulating substrate 162. The optical structure layer 161 exemplarily comprises a microstructure layer 161a, and a reflective layer 161b, made of metal, disposed on the microstructure layer 161a. In addition, to further enhance the electrical insulation property of the light redirecting film 160, the optical structure layer 161 may further include a transparent insulating layer 161c disposed on the reflective layer 161b, so as to further avoid a short circuit in electrical elements of the solar cell module.

The insulating substrate 162 may be made of one or a plurality of thin polymer films. For example, the insulating substrate may be made of one or a plurality of the following polymers: cellulose acetate butyrate, cellulose acetate propionate, cellulose triacetate, poly(meth) acrylate, polyethylene terephthalate, polyethylene naphthalate, a copolymer or mixture based on naphthalene dicarboxylic acid, polyethersulfone, polyurethane, polycarbonate, polyvinyl chloride, syndiotactic polystyrene, cyclic olefin copolymer, and a silicone-based material.

In the optical structure layer 161, the microstructure layer 161a may also be made of a polymer material. The composition of the microstructure layer may be identical with or different from that of the substrate 162. In some examples, the material is poly(meth)acrylate. In the example shown in FIG. 2, the microstructure layer 161a comprises a plurality of triangular prisms. To ensure total reflection of the light reflected by the optical structure layer 161 at the interface between the light-transmissive element 110 and the air, preferably, the vertex angles of these triangular prisms may range from 100° to 140°, preferably from 110° to 130°. In Embodiment 1, the vertex angle is set to 120°. In addition, the straight lines perpendicular to the triangular prisms' smallest cross sections are defined to be trends of the triangular prisms; and then the light redirecting film adopted in the present invention may be divided into two types. In the first light redirecting film, the trends of the triangular prisms are parallel to the length direction of the light directing film. In the second light redirecting film, the trends of the triangular prisms are at an angle with respect to the length direction of the light directing film. For example, the angle ranges from 1° to 89°. The reflective layer 161b is provided on the triangular prisms 161a. The reflective layer 161b may be formed by means of a sputtering technique. The reflective layer 161b may be made of high-reflectivity metal, such as silver, aluminum, platinum, titanium, silver alloy, aluminum alloy, platinum alloy, and titanium alloy. The reflective layer 161b may have a thickness of about 30 nm to 100 nm, and preferably have a thickness of 35 nm to 60 nm.

In order to prove that, without the need to add the transparent insulating layer, the electrical insulation property of the light redirecting film is good enough to avoid a short circuit in the solar cell module, the following experiments are carried out in this embodiment. The specific experiment content and experimental results are shown in Table 1. In these experiments, the T80X light redirecting film (not having the transparent insulating layer) made by the 3M Company is used as the light redirecting film in the solar cell module provided by this embodiment.

During the experiments, in order to prevent photon generated currents from affecting the experimental results, the solar cell in the solar cell module is replaced with a bus bar with a 5 mm width.

**Table 1**

| Concepts | Details | Materials of package layers | Lamination process | Minimal value (mm) of a gap between solder tapes | Maximum value (mm) of the gap between solder tapes | Quadtech 1868D 100VDC |
|---|---|---|---|---|---|---|
| Comparative example 1 (in the absence of a light redirecting film) | Two 3M UV-1 tapes are mounted between adjacent bus bars | 3M EVA 9120 | 5/13/145 | 0.6 | 1.5 | 1.821 T Ω |
| Comparative example 2 (in the absence of a light redirecting film) | Two 3M UV-1 tapes are mounted between adjacent bus bars | 3M EVA 9120 | 5/13/145 | 1.5 | 1.8 | 1.842-2.1TΩ |
| Experimental Example 1 (using a light redirecting film) | The light redirecting film is disposed between adjacent bus bars; the bus bars are affixed onto a rear package layer by using two 3M UV-1 tapes, and affixed onto the package layer by using two solder tapes. | 3M EVA 9120 | 5/13/145 | 1.4 | 1.8 | 1.467-1.907T Ω |
| Experimental example 2 (using a light redirecting film) | The light redirecting film is disposed between adjacent bus bars; the bus bars are affixed onto a rear package layer by using two 3M UV-1 tapes, and affixed onto the package layer by using two solder tapes. | 3M EVA 9120 | 5/13/145 | 0.6 | 2.0 | 1.780T-1.94TΩ |
| Experimental example 3 (using a light redirecting film) | The light redirecting film is disposed between adjacent bus bars; the bus bars are affixed onto a rear package layer by using two 3M UV-1 tapes, and affixed onto the package layer by using two solder tapes. | 3M EVA 9120 | 5/13/145 | 2.6 | 2.9 | 1.755 T-2.81 TΩ |

The "materials of package layers" in Table 1 refer to the materials of the front package layer and the rear package layer which both use EVA 9120 made by the 3M Company. The lamination process 5/13/145 means that, vacuuming lasts for 5 min, lamination duration is 13 min, and the lamination temperature is 145°C. Quadtech 1868D 100VDC refers to that, an insulator tester Quadtech 1868D is used to measure the resistance when a direct current voltage of 100V is applied on two adjacent bus bars.

It can be known from Table 1 that, the resistance between the bus bars in the experimental examples 1, 2, and 3 using the light redirecting film and the resistance between the bus bars in the comparative examples 1 and 2 in the absence of the light redirecting film hardly differ. That is to say, the disposition of the light redirecting film in the solar cell module of the present invention hardly causes a short circuit in the solar cell module.

Certainly, as described above, preferably, in order to further enhance the electrical insulation property of the light redirecting film 160, the transparent insulating layer 161c may be disposed on the reflective layer 161b. Specifically, the transparent insulating layer 161c may be disposed on the reflective layer 161b by means of chemical vapor deposition. The transparent insulating layer 161c may be made of silicon oxide.

The silicon oxide used to make the transparent insulating layer may include silicon dioxide. Correspondingly, the transparent insulating layer 161c may have a thickness of 20 nm to 100 nm, and preferably have a thickness of 20 nm to 50 nm.

The present invention does not particularly limit the materials of the front package layer 120 and the rear package layer 140. As a preferred implementation, the front package layer and the rear package layer may be made of EVA. Thus, the use of silicon dioxide to make the transparent insulating layer 161c can provide a good insulation property, and further bring the following advantage: Because the silicon dioxide and the EVA are almost identical in refractive index, the transparent insulating layer 161c does not affect a light path of light rays passing through the transparent insulating layer 161c and arriving at the reflective layer 161b.

The silicon dioxide has a good insulation property. Specifically, the EVA material has resistivity of 10¹³ Q • m, and the silicon dioxide has resistivity of 10¹⁷ Ω • m. Therefore, silicon dioxide with the thickness of 50 nm and an EVA material with the thickness of 500 µm have almost the same resistance. Moreover, the silicon dioxide does not vary in thickness during the lamination process, and thus the resistance of the transparent insulating layer made of the silicon dioxide remains unchanged after the lamination process.

In addition, the silicon dioxide has high hardness, and the transparent insulating layer 161c made of the silicon dioxide can prevent the reflective layer 161b from being scratched, thus ensuring high reflectivity of the reflective layer 161b. The transparent insulating layer made of the silicon dioxide is also able to isolate the reflective layer from oxygen and water vapor, thus preventing oxidization of the reflective layer 161b and ensuring the reflectivity of the reflective layer 161b.

As another specific implementation of Embodiment 1, the transparent insulating layer 161c may be made of one or a plurality of EVA, PO, and LDPE. In the present invention, an organic material for forming the transparent insulating layer may be spread on the reflective layer, and then the lamination process is performed.

As still another specific implementation of Embodiment 1, the transparent insulating layer 161c may be made of one of EVA, PO, and LDP, or a material formed after cross-linking of a plurality of EVA, PO, and LDPE. The material formed after the cross-linking has high shear-resistance, thus more efficiently avoiding a drift of the light redirecting film 160 during the lamination.

In the present invention, the disposition of the transparent insulating layer has little influence on the reflectivity of the optical structure layer. To prove this viewpoint, the reflectivity of six test samples (including a test sample 1, a test sample 2, a test sample 3, a test sample 4, a test sample 5, and a test sample 6) is measured in the present invention.

For the test sample 1, a transparent insulating layer which is 20 nm thick and made of silicon dioxide is disposed on a flat aluminum mirror film; for the test sample 2, a transparent insulating layer which is 50 nm thick and made of silicon dioxide is disposed on a flat aluminum mirror film; for the test sample 3, a transparent insulating layer which is 100 nm thick and made of silicon dioxide is disposed on a flat aluminum mirror film; for the test sample 4, aluminum oxide with the thickness of 20 nm is disposed on a flat aluminum mirror film; for the test sample 5, aluminum oxide with the thickness of 50 nm is disposed on a flat aluminum mirror film; and for the test sample 6, aluminum oxide with the thickness of 100 nm is disposed on a flat aluminum mirror film. A comparative sample is a flat aluminum mirror film provided with no oxides on the surface.

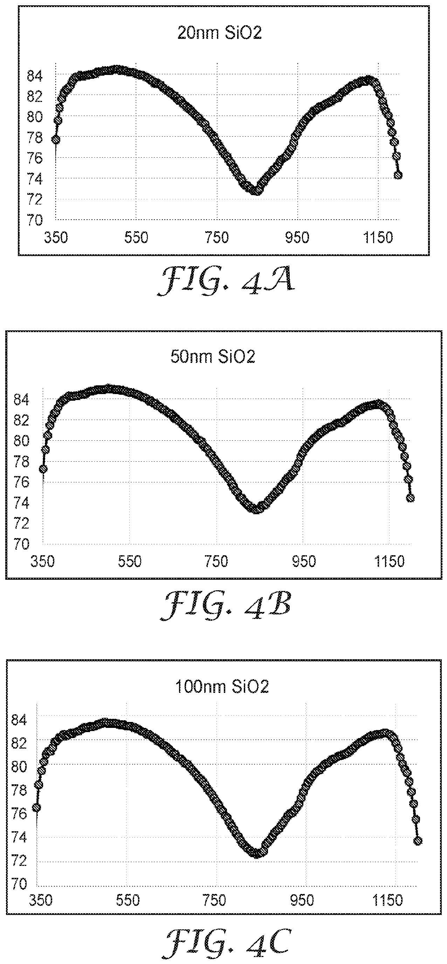

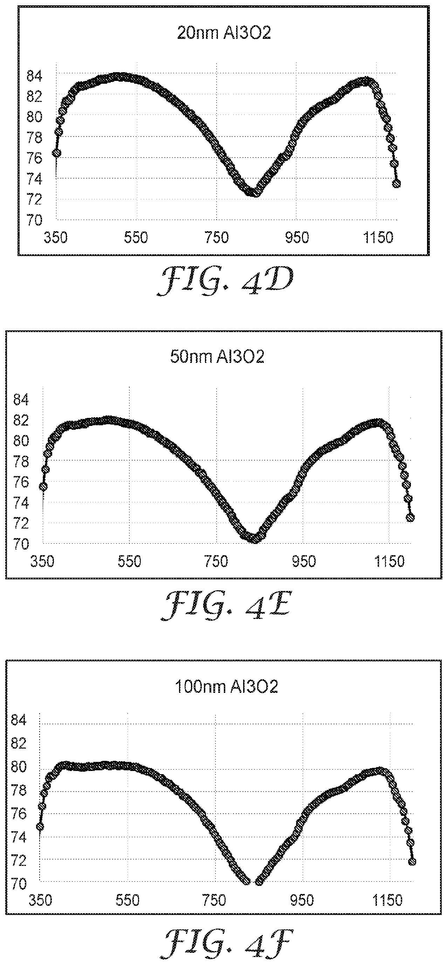

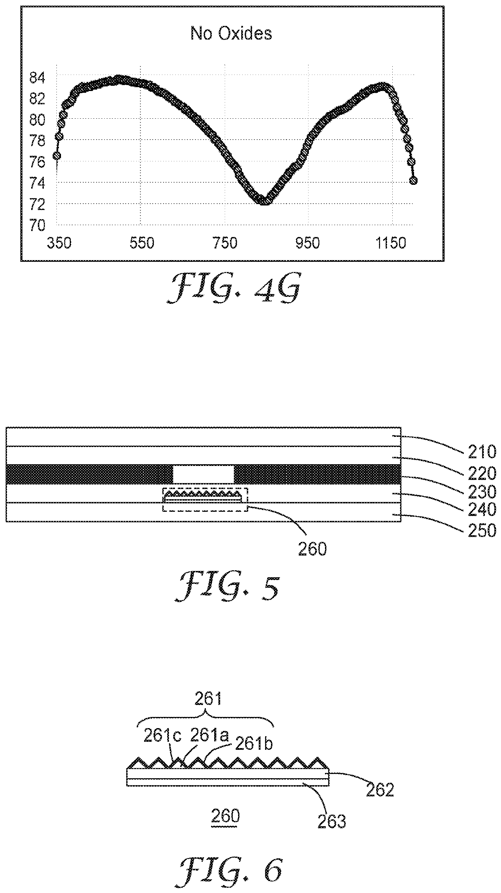

A spectrograph Lamada 900 is used to measure the reflectivity of the test samples 1, 2, 3, 4, 5, and 6 and the comparative sample. FIG. 4a shows a reflectivity curve of the test sample 1 exposed to light of different wavelengths; FIG. 4b shows a reflectivity curve of the test sample 2 exposed to light of different wavelengths; FIG. 4c shows a reflectivity curve of the test sample 3 exposed to light of different wavelengths; FIG. 4d shows a reflectivity curve of the test sample 4 exposed to light of different wavelengths; FIG. 4e shows a reflectivity curve of the test sample 5 exposed to light of different wavelengths; FIG. 4f shows a reflectivity curve of the test sample 6 exposed to light of different wavelengths; and FIG. 4g shows a reflectivity curve of the comparative sample exposed to light of different wavelengths. It should be noted that, in FIG. 4a to FIG. 4g, the abscissa indicates wavelength in nanometer, and the ordinate indicates the reflectivity in percent (%).

As shown in FIG. 4a to FIG. 4g, the reflectivity of the test sample 1 > the reflectivity of the test sample 2 > the reflectivity of the comparative sample ≥ the reflectivity of the test sample 4 > the reflectivity of the test sample 3 > the reflectivity of the test sample 5 > the reflectivity of the test sample 6. It can be known that, the aluminum oxide can reduce the reflectivity, but the silicon dioxide cannot.

As described above, the silicon dioxide is able to isolate the reflective layer from oxygen and water vapor, avoiding the formation of an oxide on the surface of the reflective layer as well as avoiding reflectivity reduction of the optical structure layer.

In Embodiment 1 of the present invention, the total thickness of the light redirecting films 160 ranges from 20 µm to 150 µm, preferably not exceeding 75 µm, and more preferably not exceeding 50 µm. In Embodiment 1 of the present invention, the total thickness of the light redirecting films 160 ranges from 20 µm to 150 µm, preferably not exceeding 75 µm, and more preferably not exceeding 50 µm.

This embodiment does not particularly limit the width of the light redirecting film 160. Preferably, the width of the light redirecting film 160 is greater than that of an interval between two adjacent solar cells. For example, when the interval between two adjacent solar cells is 3 mm, the light redirecting film 160 may have a width of 5 mm.

### Embodiment 2

Embodiment 2 of the present invention provides a solar cell module. As shown in FIG. 5, the solar cell module comprises a rear light-transmissive element 250, a rear package layer 240, a plurality of mutually spaced solar cells 230, a front package layer 220, and a front light-transmissive element 210 which are successively disposed along a thickness direction of the solar cell module. The solar cell module further comprises at least one light redirecting film 260. As shown in FIG. 6, the light redirecting film 260 comprises an optical structure layer 261. The optical structure layer 261 is disposed on a surface, inside the solar cell module, of the rear light-transmissive element 250; and corresponds to a region between the solar cells 230. The optical structure layer 261 faces the rear package layer 240, such that the optical structure layer 261 reflects the light towards an interface between the front light-transmissive element 210 and the front package layer 220. The light reflected by the optical structure layer 261 is propagated to an interface between the front light-transmissive element 220 and the air, and is then totally internally reflected from the interface between the front light-transmissive element 210 and the air to the surfaces of the solar cells 230.

Compared with Embodiment 1, Embodiment 2 has the following difference: The rear light-transmissive element 250 is used in Embodiment 2, instead of the back panel in Embodiment 1. In this embodiment, the rear light-transmissive element 250 may be made of glass. Since the rear light-transmissive element 250 has high rigidity, the light redirecting film 260 may be affixed onto the rear light-transmissive element 250. As such, during lamination of the module, no folds would be generated on the light redirecting film 260, and the light redirecting film 260 would not drift in position.

The foregoing contents are confirmed by using the test explained below.

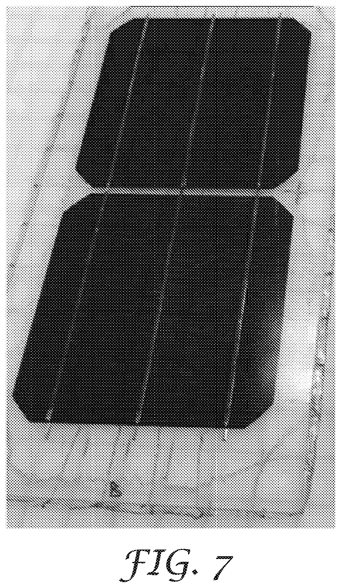

First, a black marker pen is used to draw black grids on the front package layer as reference lines. Then, the rear light-transmissive element, the light redirecting film, the rear package layer, the solar cells, the front package layer, and the front light-transmissive element are assembled into a semi-finished product, and then the lamination process is performed. The temperature of the lamination process ranges from 145°C to 160°C. The lamination process lasts for 20 min. After the lamination process is finished, the obtained solar cell module is photographed, as shown in FIG. 7. It can be seen that, the reference lines do not change much. It is thus confirmed that, when the solar cell module is a glass-combined type, if the light redirecting film 260 is affixed onto the rear light-transmissive element, namely, a glass back panel, the light redirecting film 260 is unlikely to drift in position even if lamination is performed on the module.

The disposed light redirecting film 260 can enhance light utilization of the solar cell module, and further improve the electricity generation efficiency. The principle of improving the electricity generation efficiency of the solar cell module by the light redirecting film 260 in Embodiment 2 is similar to that by the light redirecting film 160 in Embodiment 1, so the details are not described herein again.

An instance of the light redirecting film 260 applicable to this embodiment is shown in FIG. 6. The light redirecting film 260 has the same structure with the light redirecting film 160 shown in FIG. 2. Specifically, the light redirecting film 260 further comprises an insulating substrate 262 and an optical structure layer 261 disposed on the insulating substrate 262. The optical structure layer 261 comprises a microstructure layer 261a, and a reflective layer 261b, made of metal, disposed on the microstructure layer 261a. Optionally, to enhance the electrical insulation property of the light redirecting film 260, a transparent insulating layer 261c may be disposed on the reflective layer. The raw materials and the fabrication manners of the several parts of the light redirecting film 260 are identical with those of the light redirecting film 160 shown in FIG. 2, so the details are not described herein again.

Preferably, the total thickness of the light redirecting films 260 ranges from 20 µm to 150 µm, preferably not exceeding 75 µm, and more preferably not exceeding 50 µm.

A tape (for example, the UV-1 tape of the 3M Company) may be used to affix the light redirecting film 260 onto the surface, inside the solar cell module, of the rear light-transmissive element (i.e., the glass back panel). Alternatively, as shown in FIG. 2, the light redirecting film 260 may further comprise an adhesive layer disposed on the lower surface of the insulating substrate 262, so as to conveniently affix the light redirecting film 260 onto the inner surface of the rear light-transmissive element. For the solar cell module of a glass-combined type in this embodiment, because the back side thereof is also likely to receive enough sunlight, the light redirecting film 260 is expected to have an ultraviolet-proof function. Therefore, an ultraviolet absorbent may be added to an adhesive for sticking the light redirecting film 260 to the inner surface of the glass back panel, to minimize the amount of ultraviolet rays absorbed by the polymer components of the light redirecting film (including the substrate and the microstructure).

On the other hand, those of ordinary skill in the art can easily conceive that, in order to improve the electricity generation efficiency, each solar cell may be a double-sided solar cell, such that the solar cells can use the light entering the solar cell module from both the front light-transmissive element and the rear light-transmissive element.

It can be understood that, the above embodiments are only exemplary embodiments employed for illustration of principles of the present invention, and do not limit the present invention. For those of ordinary skill in the art, various variations and modifications may be made without departing from the spirit and essence of the present invention, which variations and modifications are also considered as falling within the protection scope of the present invention.

## Claims

1. A solar cell module, the solar cell module comprising: a back panel, a rear package layer, a plurality of mutually spaced solar cells, a front package layer, and a light-transmissive element, which are successively disposed along a thickness direction of the solar cell module, wherein the solar cell module further comprises at least one light redirecting film, each light redirecting film comprising an optical structure layer; the light redirecting film is disposed on a surface, opposite to a side where the solar cells are located, of the rear package layer; the position of the light redirecting film corresponds to a region between the solar cells; the optical structure layer faces the rear package layer, such that the optical structure layer reflects light towards an interface between the light-transmissive element and the front package layer; and the light reflected by the optical structure layer is propagated to an interface between the light-transmissive element and the air, and is then totally internally reflected from the interface between the light-transmissive element and the air to the surfaces of the solar cells.

2. The solar cell module according to claim 1, wherein the solar module comprises an adhesive tape, a part of the adhesive tape being adhered onto a surface, away from the rear package layer, of the light redirecting film; another part of the adhesive tape being adhered to a surface of a side, different from the side where the solar cells are located, of the rear package layer, so as to affix the light redirecting film onto the surface of the side, different from the side where the solar cells are located, of the rear package layer.

3. The solar cell module according to claim 1, wherein the light-transmissive element is made of glass; and the front and rear package layers comprise ethylene-vinyl acetate (EVA).

4. The solar cell module according to claim 1, wherein each optical structure layer comprises: a microstructure layer; a reflective layer, made of metal, disposed on the microstructure layer; and an optional transparent insulating layer disposed on the reflective layer.

5. The solar cell module according to claim 4, wherein the microstructure layer comprises a plurality of triangular prisms; and vertex angles of the triangular prisms range from 100° to 140°, preferably from 110° to 130°.

6. The solar cell module according to claim 5, wherein straight lines perpendicular to the triangular prisms' smallest cross sections are defined to be trends of the triangular prisms; and the trends of the triangular prisms are parallel to the length direction of the light redirecting film, on which the triangular prisms are located.

7. The solar cell module according to claim 5, wherein straight lines perpendicular to the triangular prisms' smallest cross sections are defined to be trends of the triangular prisms; and the trends of the triangular prisms form an angle with respect to the length direction of the light redirecting film, on which the triangular prisms are located.

8. The solar cell module according to claim 7, wherein the angle ranges from 1° to 89°.

9. The solar cell module according to claim 4, wherein the transparent insulating layer comprises silicon oxide.

10. The solar cell module according to claim 9, wherein the silicon oxide comprises silicon dioxide; and the transparent insulating layer has a thickness of from 20 nm to 100 nm, and preferably from 20 nm to 50 nm.

11. The solar cell module according to claim 4, wherein the transparent insulating layer comprises one or a plurality of the following materials: EVA, polyolefin (PO), and low-density polyethylene (LDPE).

12. The solar cell module according to claim 4, wherein the transparent insulating layer comprises one of the following materials, or a material formed after cross-linking a plurality of the following materials: EVA, PO, and LDPE.

13. The solar cell module according to any one of claims 1 to 12, wherein a total thickness of the light redirecting films ranges from 20 µm to 150 µm; preferably, the total thickness of the light redirecting films does not exceed 75 µm; more preferably, the total thickness of the light redirecting films does not exceed 50 µm.

14. A solar cell module, the solar cell module comprising: a rear light-transmissive element, a rear package layer, a plurality of mutually spaced solar cells, a front package layer, and a front light-transmissive element, which are successively disposed along a thickness direction of the solar cell module, wherein the solar cell module further comprises at least one light redirecting film, each light redirecting film comprising an optical structure layer; the optical structure layer is disposed on a surface, inside the solar cell module, of the rear light-transmissive element; the position of the optical structure layer corresponds to a region between the solar cells; and the optical structure layer faces the rear package layer, such that the optical structure layer reflects the light towards an interface between the front light-transmissive element and the front package layer; and the light reflected by the optical structure layer is propagated to an interface between the front light-transmissive element and the air, and is then totally internally reflected from the interface between the front light-transmissive element and the air to the surfaces of the solar cells.

15. The solar cell module according to claim 14, wherein the light redirecting film is disposed on the surface, inside the solar cell module, of the rear light-transmissive element by using an adhesive; and the adhesive comprises an ultraviolet absorbent.

16. The solar cell module according to claim 14, wherein the front and rear light-transmissive elements comprises glass, and the front and rear package layers are made of ethylene-vinyl acetate (EVA).

17. The solar cell module according to claim 14, wherein each optical structure layer comprises: a microstructure layer; a reflective layer, made of metal, disposed on the microstructure layer; and an optional transparent insulating layer disposed on the reflective layer.

18. The solar cell module according to claim 17, wherein the microstructure layer comprises a plurality of triangular prisms; and vertex angles of the plurality of triangular prisms range from 100° to 140°, preferably ranging from 110° to 130°.

19. The solar cell module according to claim 18, wherein straight lines perpendicular to the triangular prisms' smallest cross sections are defined to be trends of the triangular prisms; and the trends of the triangular prisms are parallel to the length direction of the light redirecting film, on which the triangular prisms are located.

20. The solar cell module according to claim 18, wherein straight lines perpendicular to the triangular prisms' smallest cross sections are defined to be trends of the triangular prisms; and the trends of the triangular prisms form an angle with respect to the length direction of the light redirecting film, on which the triangular prisms are located.

21. The solar cell module according to claim 20, wherein the angle ranges from 1° to 89°.

22. The solar cell module according to claim 17, wherein the transparent insulating layer is made of silicon oxide.

23. The solar cell module according to claim 17, wherein the transparent insulating layer is made of one or a plurality of the following materials: EVA, polyolefin (PO), and low-density polyethylene (LDPE).

24. The solar cell module according to claim 17, wherein the transparent insulating layer comprises one of the following materials, or a material formed after cross-linking a plurality of the following materials: EVA, PO, and LDPE.

25. The solar cell module according to claim 14, wherein a total thickness of the light redirecting films ranges from 20 µm to 150 µm; preferably, the total thickness of the light redirecting films does not exceed 75 µm; more preferably, the total thickness of the light redirecting films does not exceed 50 µm.

26. The solar cell module according to any one of claims 14 to 25, wherein each solar cell is a double-sided solar cell, such that the solar cells are able to use the light entering the solar cell module from both the front light-transmissive element and the rear light-transmissive element.
